# EUROPEAN PATENT APPLICATION

(11) **EP 3 003 000 A1**
(43) Date of publication of application: **06.04.2016**
(21) Application number: 14306527.4
(22) Date of filing: 30.09.2014
(51) Int. Cl.: H05K 7/20, H01L 23/467

(54) **A cooler device**

(71) Applicant: ALCATEL LUCENT, 92100 Boulogne-Billancourt (FR)
(72) Inventor: Donnelly, Brian, DUBLIN (IE); Stafford, Jason, DUBLIN (IE); Jeffers, Nicholas, DUBLIN (IE); Manning, Paul, DUBLIN (IE)
(74) Representative: Shamsaei Far, Hassan

(57) **Abstract**

An apparatus for cooling electric or electronic components comprises a first chamber and a second chamber, the chambers having walls made of thermally conductive material and a plurality of openings. A membrane is provided between the first and the second chamber which is configured to move in response to a driving force to thereby pull cooler ambient air inside a chamber and push heated air outside of another chamber.

## Description

The present disclosure relates to techniques for cooling electric or electronic equipment and components.

### BACKGROUND

One major challenge in thermal management of electronic or electric equipment is reliably maintaining component temperatures at acceptable operational levels while enabling increased functionality for such components. The challenge becomes even more significant when such increased functionality is required within equipment having reduced volumes. This is in particular the case for telecommunications equipment, although similar challenges may exist in many other sectors of industry.

Some electric or electronic equipment may have a compact structure such that components are positioned relatively close to each other and the space around the component is limited. One example of such equipment is a server chassis. The equipment may further include components that are currently cooled by natural convection where size and weight are a concern.

### SUMMARY

Some embodiments feature an apparatus comprising:
- a first chamber having thermally conductive walls with one or more openings;
- a second chamber having thermally conductive walls with one or more openings;
- a deflectable planar body; and
- a driver
wherein the planar body is located between the first chamber and the second chamber and is configured to move inside the first chamber and the second chamber in response to a driving force applied thereto by the driver.

According to some specific embodiments, in a first operating condition, the planar body is configured to move in a first direction causing an internal volume of the first chamber to decrease and an internal volume of the second chamber to increase.

According to some specific embodiments, in a second operating condition, the planar body is configured to move in a second direction causing the internal volume of the first chamber to increase and the internal volume of the second chamber to decrease.

According to some specific embodiments the first chamber has a first edge portion and the second chamber has a second edge portion and the first edge portion and the second edge portion are configured to match and be assembled with one another thereby forming a single assembled body.

According to some specific embodiments the openings are configured to allow the passage of air into and out of the interior space of the first chamber or the second chamber.

According to some specific embodiments the apparatus is configured to expel air from the first chamber and the second chamber in the form of a toroidal shaped vortex.

According to some specific embodiments the planar body located between the first chamber and the second chamber has a periphery being fixedly attached between the first edge portion and the second edge portion.

According to some specific embodiments the driver comprises an electromechanical actuator.

According to some specific embodiments the driver comprises a piezoelectric actuator.

According to some specific embodiments the planar body is configured to push air out of a chamber with a first motion and to draw air into the same chamber with a second motion being reverse of the first motion.

According to some specific embodiments the openings are arranged in accordance with natural convection and configured to be assisted by buoyancy forces.

According to some specific embodiments the piezoelectric actuator is attached at a fixed location to the first chamber and comprises a piezoelectric element attached to an end of a blade, an opposite end of the blade being attached to a surface of the planar body.

According to some specific embodiments the opposite end of the blade is attached to the surface of the planar body at a point close to a central region of the surface of the planar body,

Some embodiments feature an equipment comprising the apparatus as disclosed herein.

According to some specific embodiments the equipment is configured to operate using a natural convection cooling system, or a forced convection cooling system, or both.

These and further features and advantages of the present invention are described in more detail, for the purpose of illustration and not limitation, in the following description as well as in the claims with the aid of the accompanying drawings.

### BRIEF DESCRIPTION OF THE DRAWINGS

Figure 1 is an exemplary schematic illustration in exploded view of an embodiment of a cooler structure according to some embodiments
Figures 2a is an exemplary schematic representation of the cooler structure of figure 1 placed in thermal contact with a heat source and figure 2b shows a cross sectional view of the assembled cooler structure of figure 2a.
Figures 3a and 3b illustrate the cooler structure of figures 2a and 2b during two instances of cooling operation.
Figure 4 is a partial representation of an example of a cooling using a piezoelectric element for actuating a membrane

### DETAILED DESCRIPTION OF ILLUSTRATIVE EMBODIMENTS

In very broad terms, cooling electric and electronic equipment may be grouped into two categories: natural convection and forced convection. Natural convection solutions typically make use of large and heavy cooling mechanisms (e.g. heat sinks with large fins); however such mechanisms tend to be quite reliable. Forced convection solutions may typically involve fans or other types of blowers and forced convection heat sinks. Forced convention solution are typically capable of removing larger heat loads, as compared to natural convention solutions, for the same volume of heat sink. Heat sinks, especially those used on central processing units (CPUs), are typically large as compared to the size of the board and therefore cause significant problems to the thermal designer.

It is therefore desirable to provide a solution that would allow for both enhancing performance in natural convection solutions while maintaining reliability and meeting the performance of forced convection solutions in a smaller volume.

Embodiments of the disclosure relate to the use of a movable membrane suspended within a heat transfer structure to entrain air into and out of the structure. In the case of natural convection, the operation of the membrane would cause the entrained air to be ejected it into the surrounding ambient air, whereas in the case of forced convection it may cause a cross flow of the entrained air with the forced air flowing over the heat sources. This results in disruption to the thermal boundary layer from within and outside the heat transfer structure.

For example the cross flow may be provided by the forced air of the chassis fans. The air flow generated by the movable membrane may therefore be ejected into the cross flow air provided by the fans. This cross flow takes the heated air away from the heated surface mitigating recirculation effects.

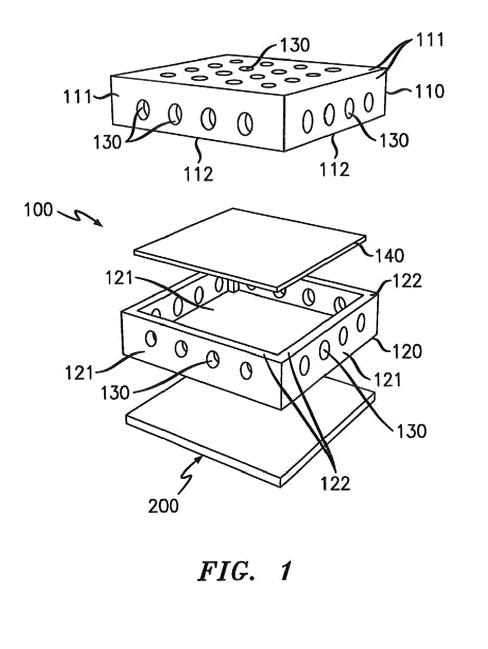

Figure 1 shows an exploded view of an embodiment of a cooler structure 100 according to some embodiments. For a better representation of the functionalities of the cooler structure 100, this structure is shown in the figure in association with a heat source 200 (i.e. an electric or electronic component that can heat up during operation and needs to be cooled).

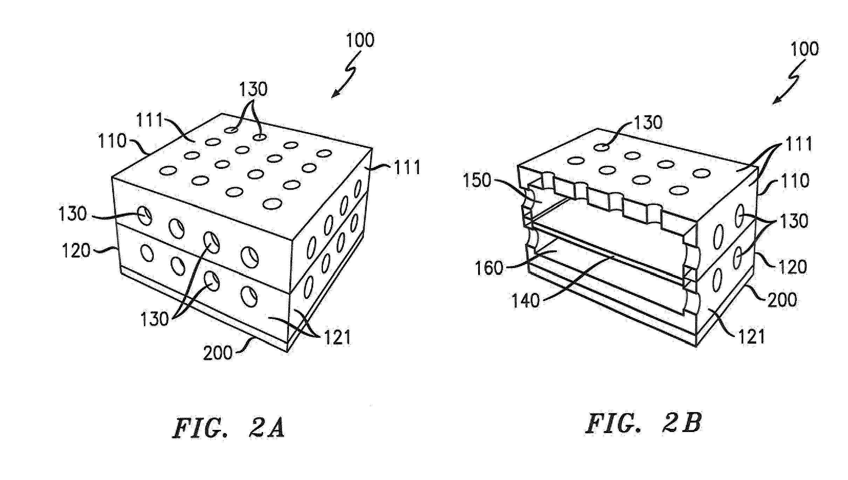

The cooler structure 100 comprises a first chamber 110 and a second chamber 120. The first chamber 110 comprises walls 111 which together form a hollow space in the form of a cavity with an open edge portion 112 (i.e. edge without a wall). Similarly the second chamber 120 comprises walls 121 which together form a hollow space in the form of a cavity with an open edge portion 122 (i.e. edge without a wall). The edge portions 112 and 122 of the first and the second chamber 110, 120, are shaped and configured so as to match and be assembled with one another thereby forming a single body in the form of a housing (shown more clearly in figure 2a). The housing thus formed may be used as a heat transfer structure, e.g. a heat sink, which may be brought into thermal contact with a heat source 200.

Although in the figures, the chambers are shown in prismatic shape with rectangular cross-section, the disclosure is not so limited and the chambers may have any confinement shape.

The first chamber 110 and the second chambers 20 may be made from high thermally conductive materials such as copper in order to efficiently conduct heat from the heat source 200 and between themselves.

For the sake of clarity with respect to the use of the term thermal conductivity, as used herein, the following clarification is provided. As it is known, many materials, and even from a pure theoretical standpoint any material, may be considered to be thermally conductive (thus having heat transfer capabilities) as each material has a certain level of thermal conductivity, even if in some cases such level is very low. However, within the context of the present disclosure, a person of ordinary skill in the related art would be able to distinguish a material which is considered in the art as thermally conductive from one which is not so considered, such as for example a thermal insulator.

By way of still further clarification, it is noted that within the context of the present disclosure, any material having a thermal conductivity equal or greater than about 1W/mK (Watts per Meter Kelvin) may be considered as a thermally conductive material. Conversely, any material having a thermal conductivity of less than about 1W/mK may be considered as thermally non-conductive. Within the thermal conductivity range described above, a thermal conductivity greater than 100W/mK may be considered as a high thermal conductivity value and one within the range of 1-100W/mK may be considered as an acceptable value.

Referring back to figure 1, it can be observed that each of the first and the second chambers has openings 130 provided on one or more walls 111, 121 thereof. The openings 130 are configured to allow the passage of air into and out of the interior space of the chambers. In figure 1 the openings are shown in the form of circular holes, however this is only exemplary and other shapes and/or structures of openings may likewise be used within the scope of the present disclosure.

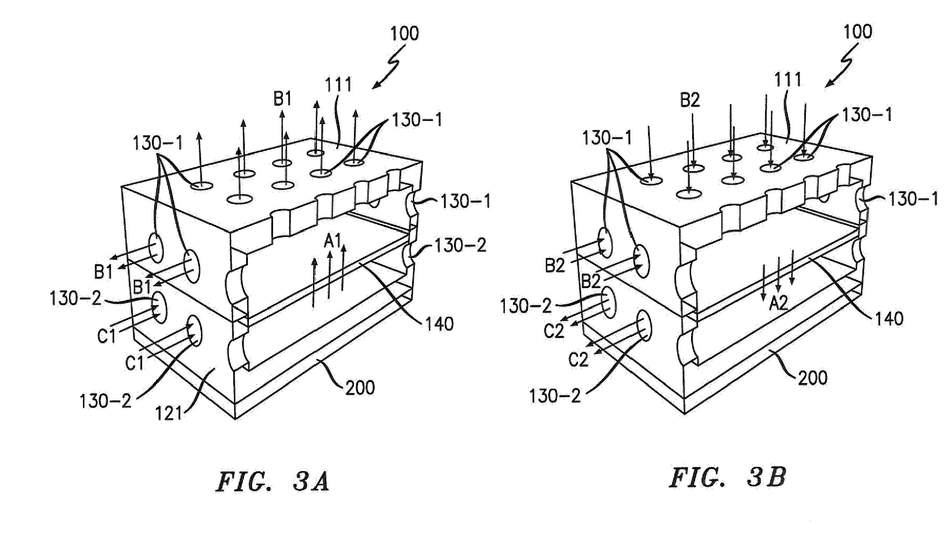

The cooler structure 100 further comprises a movable membrane 140. The movable membrane is preferably mounted so as not to obstruct the thermal path between the first and the second chamber 110, 120. The operation of the movable membrane will be described in further detail with reference to figures 3a and 3b.

Figure 2a shows an assembled view of the cooler structure 100 of figure 1 which is in thermal contact with a heat source 200 (e.g. electronic component) and figure 2b shows a cross sectional view of the assembled cooler structure of figure 2a. In these figures like elements have been provided with like reference numerals as those of figure 1.

As can be seen more clearly in figure 2b, the membrane 140 is a planer body and is located between the first chamber 110 and the second chamber 120 with its periphery (i.e. its outer boundaries) being fixedly attached at a suitable location between the edge portions 112 and 122 of the first and the second chamber 110, 120. In this manner the edge portions 112 and 122 act as a fixed frame for the membrane 140 and the latter is therefore capable of performing an oscillating movement in the regions closer to its center while its peripheral borders are fixed, in a fashion similar to a trampoline.

Still with reference to figure 2b, it may be seen that a first hollow space 150 is provided between the membrane 140 and the walls 111 of the first chamber 110 and a second hollow space 160 is provided between the membrane 140 and walls 121 of the second chamber 120.

With the above arrangement, the operation of the cooler structure 100 will be described with reference to figures 3a and 3b. These figures represent the same assembled structure as shown in figure 2b, with the difference of representing operation. In figures 3a ad 3b, unless otherwise provided, like elements have been provided with like reference numerals as those of figures 1, 2a and 2b.

The cooler structure 100 is assumed to be brought in thermal contact with a hot component such as the heat source 200. As the walls 111 of the first chamber 110 is in thermal contact with the walls 121 of the second chamber 120, and due to the fact that the walls 111 and 121 are thermally conductive, their assembled structure acts as a heat transfer medium, e.g. a heat sink, which is capable of removing heat from the heat source 200.

As the walls 111 and 121 heat up, the air adjacent to them also heats up through conduction and/or convection. This may occur at both the inner and outer surfaces of the chambers 110 and 120.

The cooling process comprises two main phases: suction and blowing. Referring first to figure 3a, it is assumed that the membrane is moving in a first direction shown by arrows A1. The movement of the membrane 140 in the direction of arrow A1, decreases the internal volume of the first chamber 110. This causes the air to be forced to move out of the first chamber 110 through openings 130-1 in the walls 111 of the first chamber 110, as shown by arrows B1. This operation may be considered as the blowing phase in the first chamber 110. Simultaneously, with the same movement of the membrane 140 in the direction of arrow A1, the internal volume of the second chamber 120 is increased thus causing air to be pulled into the second chamber 120 through openings 130-2 in the walls 121 of the second chamber 120, as shown by arrows C1. This operation may be considered as the suction phase in the second chamber 120.

In the blowing phase in the first chamber 110, and assuming that walls 111 and 121 of the cooler structure are heated up as a consequence of their thermal contact with the heat source 200 and that such heat is transferred to the air inside the first chamber 110 (and also the second chamber), the blowing operation causes the heated air inside the first chamber to be ejected (pushed out) from the first chamber 110 to the surrounding ambient. This operation contributes to the removal of heat from the first chamber 110.

In the simultaneous suction phase in the second chamber 120, and under the same assumptions provided above, the suction operation causes cooler air from the ambient to be pulled into the second chamber 120. This operation contributes to the removal of heat from the second chamber 120.

Referring now to figure 3b, it is to be noted that the operation is very similar to that of figure 3a, with the difference that the blowing and suction phases are reversed in the first and the second chambers.

In this case, it is assumed that the membrane is moving in a second direction shown by arrows A2. When the membrane 140 moves in the direction of arrow A2, air is forced to move inside the first chamber 110 through openings 130-1 in the walls 111 of the first chamber 110, as shown by arrows B2. This operation is therefore the suction phase in the first chamber 110. Simultaneously, with the same movement of the membrane 140 in the direction of arrow A2, air is pushed out of the second chamber 120 through openings 130-2 in the walls 121 of the second chamber 120, as shown by arrows C2. This operation is therefore considered as the blowing phase in the second chamber 120.

In the suction phase in the first chamber 110, and assuming that walls 111 and 121 of the cooler structure are heated up as a consequence of their thermal contact with the heat source 200 and that such heat is transferred to the air inside the first chamber 110 (and also the second chamber) the suction operation causes cooler air from the ambient to be pulled into the first chamber 110. This operation contributes to the removal of heat from the first chamber 110.

In the simultaneous blowing phase in the second chamber 120, and under the same assumptions provided above, the blowing operation causes the heated air inside the second chamber to be ejected (pushed out) from the second chamber 120 to the surrounding ambient. This operation contributes to the removal of heat from the second chamber 120.

The above process may be repeated at any suitable frequency and/or stroke length which is high enough to result in large heat transfer rates. The action of suction and blowing results in values of heat transfer coefficient that may be significantly larger than the known techniques due to mixing of air within the chambers and outside them. This is because the cool air drawn in the chamber has chaotic flow. This chaotic air flow comes in close contact with the heated surface thinning the thermal boundary layer and increasing heat transfer to the air. The air thus heated is then expelled away from the heated surface allowing more, cooler air to flow in and take its place.

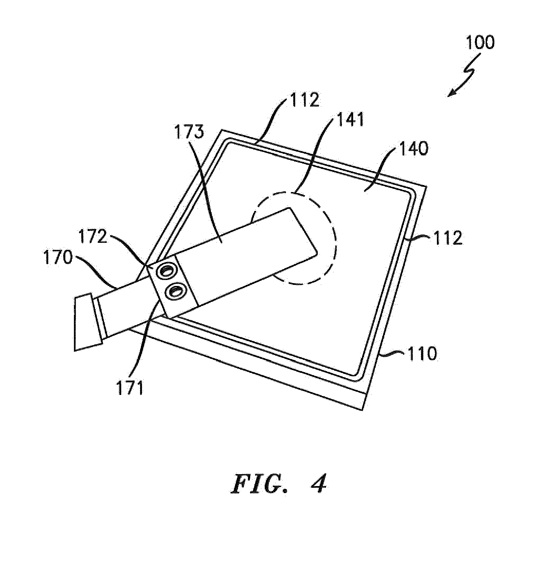

The membrane 140 within the cooler structure 100 may be actuated by a driver in such a way that it moves in the directions A1 and A2 in an oscillating manner. This can be achieved by using electromechanical (electromagnet) actuators or by using a piezoelectric actuators as will be described with reference to figure 4. The membrane may be flexible or solid, although light solid materials are advantageous as they would allow for a more efficient operation. An example of a solid material is thin carbon fiber sheet which is light and rigid. An example of a flexible material is silicone rubber. However, in either case, the membrane is deflectable such that at least a portion of the body of the membrane is capable of moving in response to an actuating force of the driver, thereby pushing air from one chamber with its motion and draw air back into the same chamber with its reverse motion.

In natural convection applications, the openings 130 may be arranged in a manner to meet natural convection requirements and be assisted by buoyancy forces. For example it may preferable to provide the opening such that they point upwards and outwards relative to the cooler structure 100.

In forced convection applications packets of heated air are entrained in the cross flow. In this configuration, in which the cooler structure is mounted on a hot component within a cross flow, the pressure drop across the structure is reduced due to the lack of a finned surface and the use of pulsed air.

The proposed solution offers important advantages over the known solution, such as a small form factor, lower weight, higher reliability and efficient cooling for hot components.

Figure 4 is a partial representation of an example of a cooling structure in which use is made of a piezoelectric element for actuating the membrane. In this figure, like elements have been provided by like reference numerals as those of the previous figures. However it is to be noted that figure 4 only illustrates one chamber, the membrane and the piezoelectric actuator and the second chamber is removed for facilitating the better understanding of the description.

As seen in figure 4, the partially illustrated cooling structure 100 comprises a first chamber 110 and a membrane 140 fixedly attached, at the periphery borders thereof, to the open edge 112 of the first chamber 110. With this arrangement, membrane 140 may be made to oscillate preferably at regions closer to its center (illustratively shown as area 141) while its periphery is fixed as already described above.

A piezoelectric actuator 170 is attached at a fixed location 171 to the first chamber 110 for example at a convenient point on the open edge 112 as shown in the figure. The piezoelectric actuator 170 comprises a piezoelectric element 172 attached to an end of a cantilever body 173 (or blade). The opposite end of the blade 173 is attached at a convenient point to a surface of the membrane. Those skilled in the art would understand that the point of attachment of the opposite end of the blade 173 to the membrane may preferably be selected close to the central region 141 of the surface of the membrane so as to ensure larger oscillation amplitude at the attachment point. However, the disclosure is not so limited and the point of attachment between the blade and the surface of the membrane may be at other locations that are not so close to the central region 141.

The piezoelectric element 172 is capable of exhibiting a mechanical stress in response to an electric excitation (current or voltage) applied thereto. The mechanical stress is exhibited in the form of a movement. As the piezoelectric element 172 is attached to an end of the blade 173, the stress caused on the piezoelectric element is transferred to the blade causing the blade to move. If the electric excitation applied to the piezoelectric element 172 is in form of an alternate current or voltage, the blade may then oscillate at the end opposite to the end which is attached to the piezoelectric element 172. As said opposite end is in turn attached to the center region of the membrane, the latter may undergo an oscillation movement in the central region 141 in the direction of arrows A1 and A2 in figures 3a and 3b. In this manner the cooler structure 100 may be actuated by the piezoelectric actuator and perform the operations as described with reference to figures 3a and 3b.

It is to be noted that the in the blowing operation, the air may be expelled from the chambers in the form of a toroidal shaped vortex having sufficient momentum to travel away from the surface of the walls at a high velocity. This action may be considered similar to moving of a 'packet' of heated air away from the heated surface. Oscillating the membrane at a high frequency may result in generating a train of the heated vortex packets which are then ejected from the surface.

It is to be noted that different designs of the openings may contribute to improving efficiency and heat transfer effectiveness. Furthermore the motion of the membrane may have a direct effect on the efficiency in producing the above-mentioned vortex packets. Different membranes may be designed according to different oscillation frequencies and/or stroke lengths (the maximum amplitude of displacement of the membrane during operation). It is however noted that as the frequency increases for a given stroke length, the change in direction of oscillation of the membrane becomes more abrupt thereby providing a stronger momentum which enhances the generation of vortex packets at the exit of the openings for each period of oscillation.

The generation of vortex packets is advantageous, although not mandatory, for the operation of the apparatus as disclosed herein. This is because in conventional fans and heat sinks, the air at the leading edge of the heat sink is typically coolest and therefore absorbs the higher amounts of heat. As this air moves along the heat sink, it heats up and therefore it typically cannot absorb as much as it could at the leading edge of the flow. The generating of vortex packets contributes to ejecting the heated air away from the heated surface thereby overcome above drawback.

Another advantage of the present solution is that as it avoids the use of bearings and sliding friction surfaces (as used e.g. in rotary fans), reliability is substantially increased relative to axial fans. Furthermore, by locating the oscillating membrane within the thermally conducting surface itself the size of the whole structure may be reduced substantially without sacrificing performance.

The various embodiments of the present invention may be combined as long as such combination is compatible and/or complimentary.

Further it is to be noted that the list of structures corresponding to the claimed means is not exhaustive and that one skilled in the art understands that equivalent structures can be substituted for the recited structure without departing from the scope of the invention.

## Claims

1. An apparatus comprising:
- a first chamber having thermally conductive walls with one or more openings;
- a second chamber having thermally conductive walls with one or more openings;
- a deflectable planar body; and
- a driver
wherein the planar body is located between the first chamber and the second chamber and is configured to move inside the first chamber and the second chamber in response to a driving force applied thereto by the driver.

2. The apparatus of claim 1, wherein in a first operating condition, the planar body is configured to move in a first direction causing an internal volume of the first chamber to decrease and an internal volume of the second chamber to increase.

3. The apparatus of claim 2, wherein in a second operating condition, the planar body is configured to move in a second direction causing the internal volume of the first chamber to increase and the internal volume of the second chamber to decrease.

4. The apparatus of any one of the preceding claims, wherein the first chamber has a first edge portion and the second chamber has a second edge portion and the first edge portion and the second edge portion are configured to match and be assembled with one another thereby forming a single assembled body.

5. The apparatus of any one of the preceding claims, wherein the openings are configured to allow the passage of air into and out of the interior space of the first chamber or the second chamber.

6. The apparatus of any one of the preceding claims, configured to expel air from the first chamber and the second chamber in the form of a toroidal shaped vortex.

7. The apparatus of any one of the preceding claims 4 to 7, wherein the planar body located between the first chamber and the second chamber has a periphery being fixedly attached between the first edge portion and the second edge portion.

8. The apparatus of any one of the preceding claims wherein the driver comprises an electromechanical actuator.

9. The apparatus of any one of the preceding claims 1 to 8, wherein the driver comprises a piezoelectric actuator.

10. The apparatus of any one of the preceding claims wherein the planar body is configured to push air out of a chamber with a first motion and to draw air into the same chamber with a second motion being reverse of the first motion.

11. The apparatus of any one of the preceding claims, wherein the openings are arranged in accordance with natural convection and configured to be assisted by buoyancy forces.

12. The apparatus of claim 9, wherein the piezoelectric actuator is attached at a fixed location to the first chamber and comprises a piezoelectric element attached to an end of a blade, an opposite end of the blade being attached to a surface of the planar body.

13. The apparatus of claim 12, wherein the opposite end of the blade is attached to the surface of the planar body at a point close to a central region of the surface of the planar body.

14. An equipment comprising the apparatus of any one of the claims 1 to 13 and a heat source.

15. The equipment of claim 14, configured to operate using a natural convection cooling system, or a forced convection cooling system, or both.
